# EUROPEAN PATENT SPECIFICATION

(11) **EP 1 151 308 B1**
(45) Date of publication and mention of the grant of the patent: **12.10.2005**
(21) Application number: 00905023.8
(22) Date of filing: 04.02.2000
(51) Int. Cl.: G01R 1/073, H05K 13/08

(54) **COUPLING AND CENTERING SYSTEM, PARTICULARLY FOR ALIGNING PRINTED CIRCUITS IN TESTING PROCEDURES**
KOPPLUNGS- UND ZENTRIERUNGSSYSTEM, INSBESONDERE FÜR DIE AUSRICHTUNG VON GEDRUCKTEN SCHALTUNGEN IN EINEM TESTVERFAHREN
SYSTEME DE COUPLAGE ET CENTRAGE CON U NOTAMMENT POUR ALIGNER DES CIRCUITS IMPRIMES DANS DES PROCEDURES DE TEST

(30) Priority: 09.02.1999 IT VR990013
(43) Date of publication of application: 07.11.2001
(73) Proprietor: De Rossi, Michele, 37020 Arbizzano di Negrar (IT)
(72) Inventor: De Rossi, Michele, 37020 Arbizzano di Negrar (IT)
(74) Representative: Reniero, Cirillo Silvano
(86) International application number: PCT/EP2000/000896
(87) International publication number: WO 2000/048007

(56) References cited:
- EP-A- 0 840 131
- US-A- 5 395 099

## Description

### Technical field

The present invention relates to a system for aligning a circuit board with respect to a structure and can be used in particular in apparatuses for automatic testing of circuits, such as bare printed circuits.

### Background art

In general, such apparatuses are complex measurement instruments with decision-making and comparison capabilities, arranged to apply electrical stimuli to a number of nodes of a printed circuit and measure the effects thereof at other nodes. The results of the measurements are then compared with expected theoretical values and, in case of divergence, a decision is taken as to whether to signal a manufacturing error or to perform other operations and countermeasures, e.g. to check that the error is not a mere measurement error.

As it is known, various kinds of automatic testing devices are available according to the objects to be tested: bare printed circuits, integrated circuits, electronic boards and systems.

Testing of printed circuits, which are the typical objects to which the present invention is directed, comprises checking the continuity of the tracks and their mutual insulation. To do this, it is necessary to contact the ends of all the track segments and measure the resistance thereof. Such a resistance should be very small (e.g. < 1 Ω), if the contacts are on the same track and should be very high (e.g. > 10 MΩ), if the contacts are on different tracks. Usually the contacts do not occur directly on the tracks but on suitably provided test pads electrically connected to the tracks. In any case, the pads are very small targets, that being particularly true with the smaller pads of SMD circuits. Alignment problems in fact occur sometimes because the tolerances of the mechanical centering holes of the printed circuits are comparable to the dimensions of the SMD pads.
An example of a conventional testing device is provided in US-5 395 099.

A probing apparatus used is provided with a bed of nails or needles and is structured as follows. First of all, such an apparatus comprises a rigid support or test grid fixture, in which holes are formed for conducting probing elements being inserted. Such a rigid support is constituted by parallel plates of insulating material (e.g. vetronite or polycarbonate) which are kept spaced apart by means of spacers and formed with coaxial holes, into each of which a respective probing element is to be inserted. The probing elements (nails or needles) are provided with a suitable probing head (which can be knurled or conical and made of a specific material, e.g. gold-plated). The needles can be inserted in hollow cylinders from which they protrude with their end provided with the head, whereas they press, a spring inside the cylinder at their other end. The assembly constituted by spring, needle and cylinder is sometimes termed probe. The probe is enclosed in an enclosure (termed jacket) which in turn enters the holes in the rigid support. Centering pins for a printed circuit with respect to the rigid support are instead inserted in other holes provided in the rigid support.

In order to produce a contact, a printed circuit is pressed against the heads of the needles. The spring has dimensions chosen so that at the end of each stroke the force applied by the head to the printed circuit is sufficient to ensure a good contact. Since many probes are provided, the total force required to press all the probes may be considerable.

The circuit must be properly aligned with the support into which the needles are inserted, in order to allow their heads to reach the preset targets to be stimulated. If sufficiently precise alignment is not achieved due to inaccuracies in the production of the printed circuit, the measurements are biased and the machine detects open-circuit or closed-circuit errors that do not exist in reality.

The system currently most widely used to determine the mutual position of a printed circuit and of a fixed support use is made of hole-and-pin couplings with at least two pins. Each pin is inserted in a rigid support and can have a spring which is similar to the springs of the probes. The pin point can be cylindrical or conical and is arranged to be inserted into a suitable hole formed in the printed circuit or in a plate on which the circuit is mounted. Should the test be performed on one side only, use is made of a rigid support which lies below the circuit; should the test be performed on both sides, another support located above the circuit is used and said second support is aligned with respect to the underlying support rather than being aligned directly with respect to the printed circuit.

Nowadays, substantially two methods are used to center poorly aligned circuits: automatic alignment and manual alignment.

Automatic alignment is useful when the error is not systematic within the production batch and therefore the alignment operations differ from one circuit to another. The machine performs a first measurement of the continuity of the tracks when the circuit is not aligned. This results in errors being detected indicating an open circuit. The machine for automatic alignment, by means of an algorithm which compares the results with data on the geometry of the circuit, is capable of distinguishing whether the open-circuit errors are real or simply measurement errors due to misalignment. At this point, the machine uses actuators which include step motors to produce small movements of the printed circuit so as to achieve alignment. As a whole, the actuators are capable of causing small rotary and translatory motions of the circuit with respect to the support. The printed circuit rotates and/or performs a translatory motion while laying on the same plane on which it was laid initially (in practice, it moves so as to remain parallel to itself).

The manual alignment system is instead convenient if the batch of printed circuits to be tested has a substantially constant error in each printed circuit. In this case, it is possible to perform a manual alignment for all the circuits.

Manual alignment is performed through the following steps. A few tests are performed with the system in its nominal position for circuits with zero error. The nominal position is found by optically aligning some references. By means of an optical system constituted by a microscope (with graduated grid), the position of the markings left by the needles on the SMD pads of the circuit being tested is measured with respect to a reference position. Manual alignment is then performed by acting on lever systems which allow minute and precise movements of the printed circuit to be performed. Alignement can be performed otherwise by manually powering through switches the individual actuators used in the automatic system.

Another method of obtaining manual alignment comprises using a perforated plate with two square matrix arrays of holes and two blocks, each of which is perforated with a matrix array of holes similar to the array provided on the plate but having a slightly different pitch between the holes. The blocks rigidly couple to the circuit, whereas the plate is rigid with the nail support. The blocks are connected to the plate by means of two pins inserted in the holes. In this manner, each block is subjected to a movement whose extent is equal to the error associated with the lines and columns to which the holes being used belong. This movement has independent components according to a system of two perpendicular Cartesian axes which are parallel to the lines and columns of the matrix array of the plate.

Automatic or manual testing equipment, however, has a number of drawbacks.

Automatic testing requires complicated and expensive apparatuses which also require considerable care and maintenance.

Manual adjustment systems, too, are an assembly of mechanisms which always make the entire testing machine more complicated and delicate.

### Disclosure of the Invention

The main object of the present invention is to eliminate or drastically reduce the above mentioned drawbacks faced with known apparatuses and methods.

Another object of the present invention is to provide a simple and extremely effective solution to the problem of alignment without using additional apparatuses or mechanisms but merely by providing very small modifications to elements which are already present in a testing equipment and specifically in the test fixtures.

This and other objects which will become better apparent hereinafter are achieved by a system for connecting and centering a board to be tested which comprises one or more test fixtures or grids and adjustment and locking means which make it possible to choose and rigidly fix the position of the board with respect to said structure, and characterized in that it comprises at least one pin which is mechanically coupled to a respective coupling seat in said structure and has one eccentric end designed to mechanically couple with locator elements on the board to be tested or to the end of a respective pin which is, in turn, connected to the board to be tested, the mechanical coupling being such as to allow each pin to be positioned with preset degrees of rotation about their own axes, thereby inducing a corresponding rotary and translatory motion, owing to the eccentric end of each pin, of the board on its lying plane.

### Brief description of the drawings

Further features and advantages of the present invention will become better apparent from the following detailed description of currently preferred embodiments thereof, illustrated only by way of non-limitative example in the accompanying drawings, wherein:
Figure 1 is a perspective view of a portion of printed circuit;
Figure 2 shows a pin with an eccentric tip;
Figure 3 is a top view of the pin of Figure 2;
Figures 4 and 5 are cross-section views, taken along the lines IV-IV and V-V, respectively of the pin of Figure 2;
Figure 6 shows another embodiment of pin with an eccentric tip;
Figure 7 is a top view of the pin of Figure 6;
Figures 8 and 9 are cross-section views, taken along the lines VIII-VIII and IX-IX, respectively, of the pin of Figure 6;
Figure 10 is a partial view of another embodiment of a pin with an eccentric tip;
Figure 11 is a top view of the pin of Figure 10;
Figure 12 is a cross-section view taken along the line XII-XII of Figure 10;
Figure 13 is a partial view of another embodiment of a pin with an eccentric tip;
Figure 14 is a cross-section view taken along the line XIV-XIV of Figure 13;
Figures 15 and 16 are an elevation view and a plan view, respectively, of a pin with an eccentric female end;
Figures 17, 18 and 19 are each a cross-section view taken along the lines XVII-XVII, XVIII-XVIII and XIX-XIX, respectively, of Figure 15;
Figure 20 is a partial view of another embodiment of female pin with an eccentric end;
Figure 21 is a top view of Figure 20;
Figure 22 is a partial top view of a pin receiving and orientation hole formed in an insulating plate or sheet;
Figure 23 shows a cross-section view, taken along the line XXIII-XXIII of Figure 22;
Figure 24 is a partial top view of another hole for receiving and steering of a pin;
Figure 25 is a cross-sectional view taken along the line XXV-XXV of Figure 24;
Figure 26 is a partial perspective view of a cylindrical slotted stem of a pin with no tip;
Figure 27 is a partial top view of a hole for receiving and steering the pin of Figure 26;
Figure 28 is a sectional view, taken along the line XXVIII-XXVIII of Figure 27;
Figure 29 is a partial perspective view of a square slotted stem of a pin with no tip;
Figure 30 is a partial top view of a hole for receiving and steering the pin of Figure 29;
Figure 31 is a perspective view of a pin with an eccentric tip, inserted in the appropriately provided receiving hole formed in an insulating plate;
Figures 32 and 33 are views of two male-female couplings between eccentric pins;
Figure 34 is a partial cross-sectional side view of a test fixture or frame which is formed by four superimposed plates made of insulating material, with an eccentric pin inserted therein; and
Figure 35 is a view of a belt system for simultaneously steering multiple eccentric pins mounted on the same frame.

In the accompanying drawings, identical or similar parts or components are designated by the same reference numerals.

### Ways of carrying out the invention

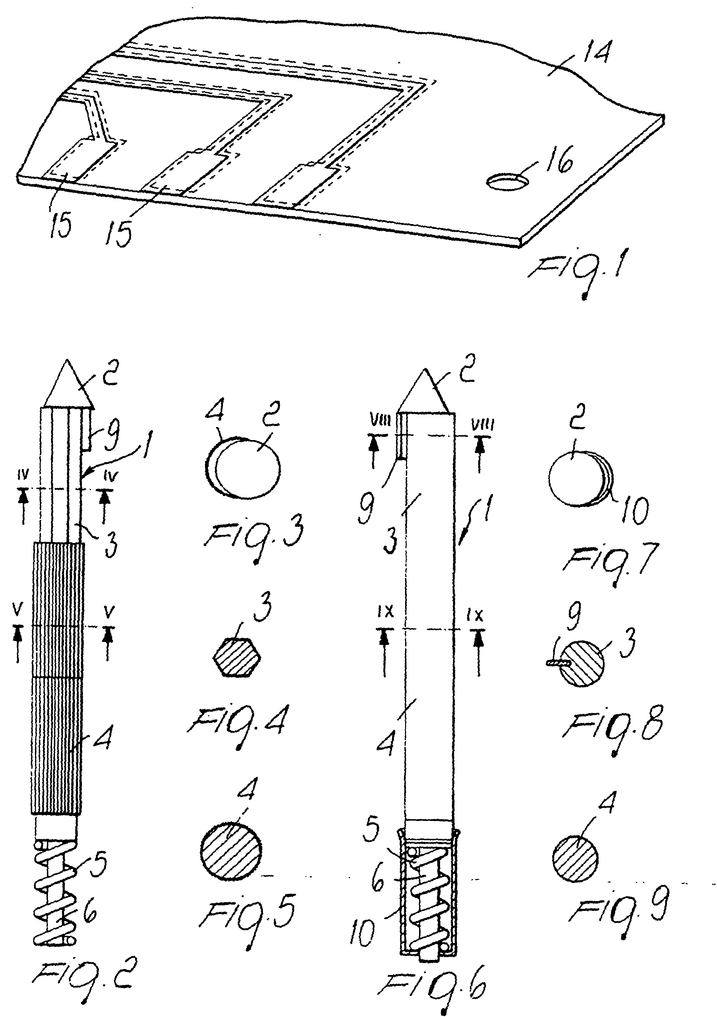

Figure 1 illustrates a possible cause of alignment problems. Tracks and measurement pads 15 are deposited on a board 14 made of insulating material of a printed circuit; as a matter of fact said pads are displaced with respect to their design position, shown by dashed lines. Accordingly, they are shifted with respect to a reference centering hole 16. Sometimes, the hole 16 itself, formed by a drilling or punching operation, has excessively large tolerances and thus it is located at a distance with respect to the pads which differs from design specifications.

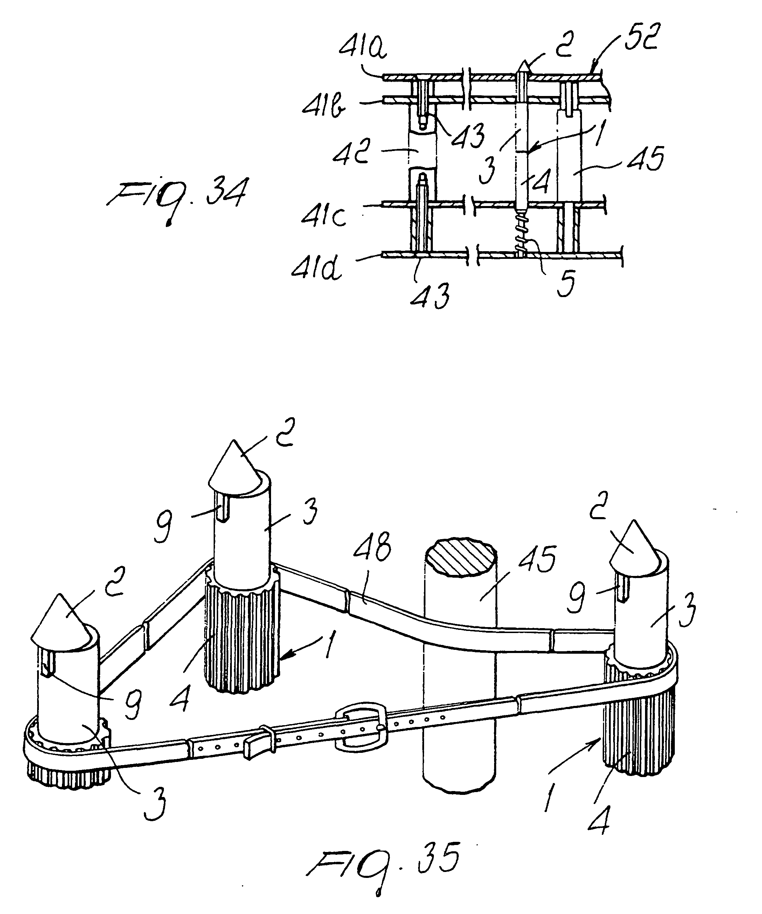

Figure 34 shows a portion of a test fixture or frame 52 formed by stacking insulating plates 41a, 41b, 41c, and 41d which are mutually fixed by means of locking elements 42 and screws 43 and kept spaced apart from one another by spacers 45. Multiple centering pins 1 are accommodated in the frame 52 and designed to match with a respective reference centering hole 16 in a board 14 to be tested.

Figures 2 to 8 illustrate two centering pins 1 and 7 which terminate with a conical tip 2 whose axis of symmetry is parallel to, but does not coincide with, the axis of symmetry of the stem of said pins.

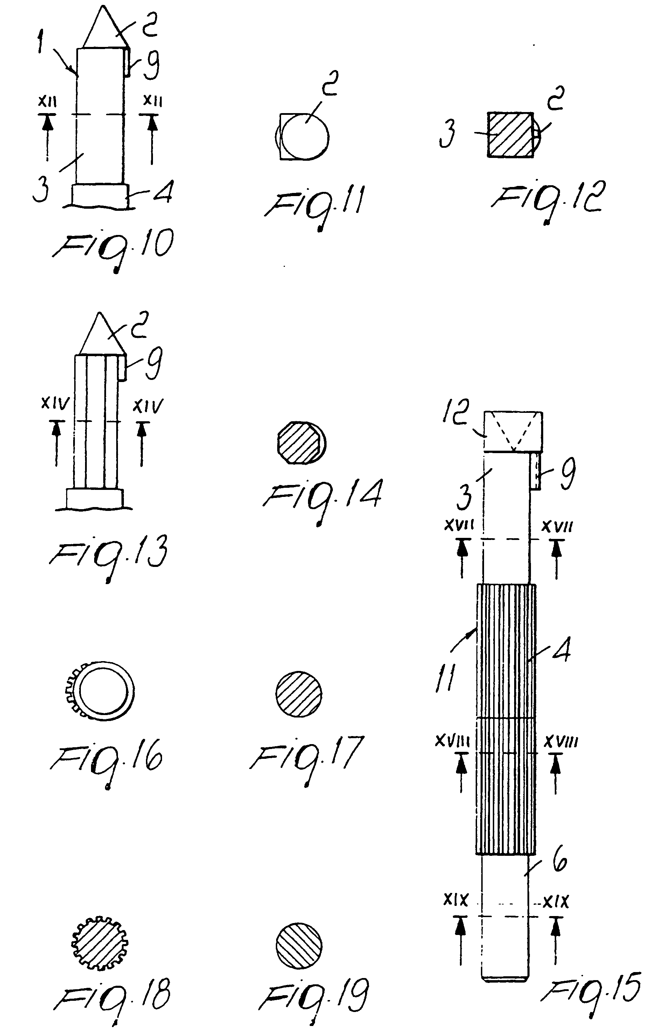

More particularly, with reference to Figures 2 to 14, the stem of the centering pin 1 provided with a conical tip 2 has a portion 3 which is adjacent to the conical tip 2 and is hexagonal in cross-section (Figures 2 and 3), circular in cross-section (Figures 6 and 7), octagonal in cross-section (Figures 13 and 14), square in cross-section (Figures 10-12); an intermediate portion 4, which can be grooved (Figures 2 and 4) or cylindrical (Figures 6, 8 and 10-12); and a cylindrical end portion 6 which can be smaller in diameter and on which a helical spring 5 can be wound (Figures 2 and 6), possibly partly protected by a receiving cup 10 (Figure 6).

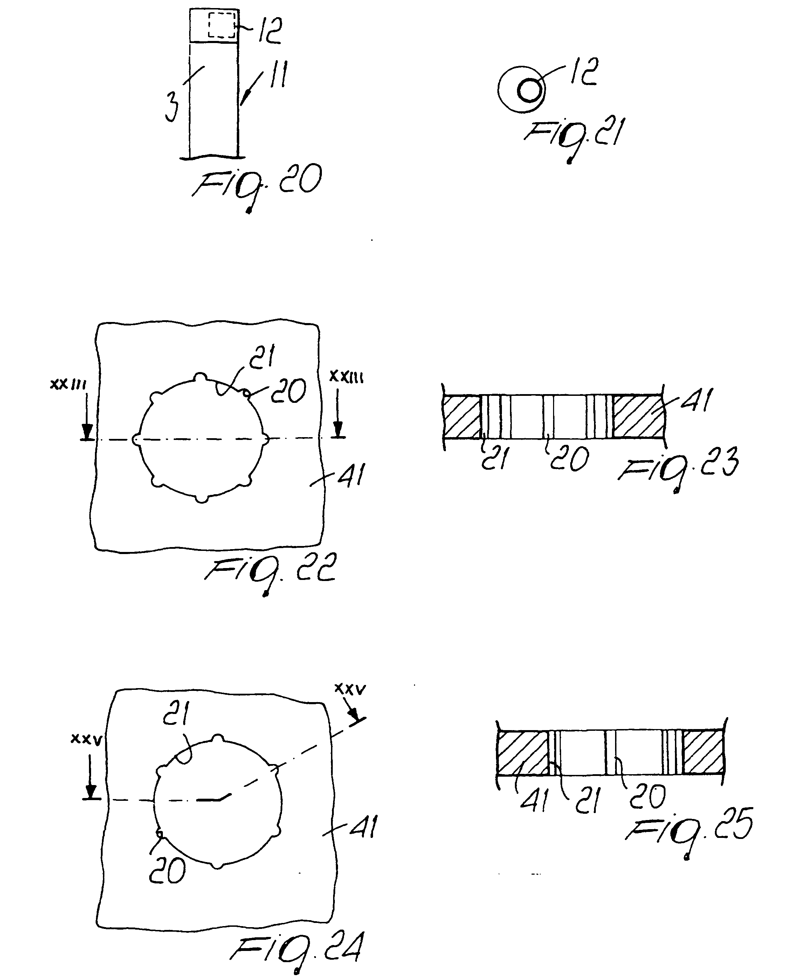

Figures 15 to 21 illustrate centering pins with an eccentric female-type end 12, which are structured like the male pins 1 and provided with a protruding key 9 which is designed to engage with one of the recesses 20 uniformly angularly spaced along the rim of each receiving hole 21 formed in a plate 41 of a test frame 52 (Figures 22 to 25).

Owing to matching between key 9 and recess 20, it is possible to preset and control the orientation of the eccentricity of the pins within angular ranges of 40° in the case eight recesses 20 per hole 21 or of 60° where six recesses are provided and so forth.

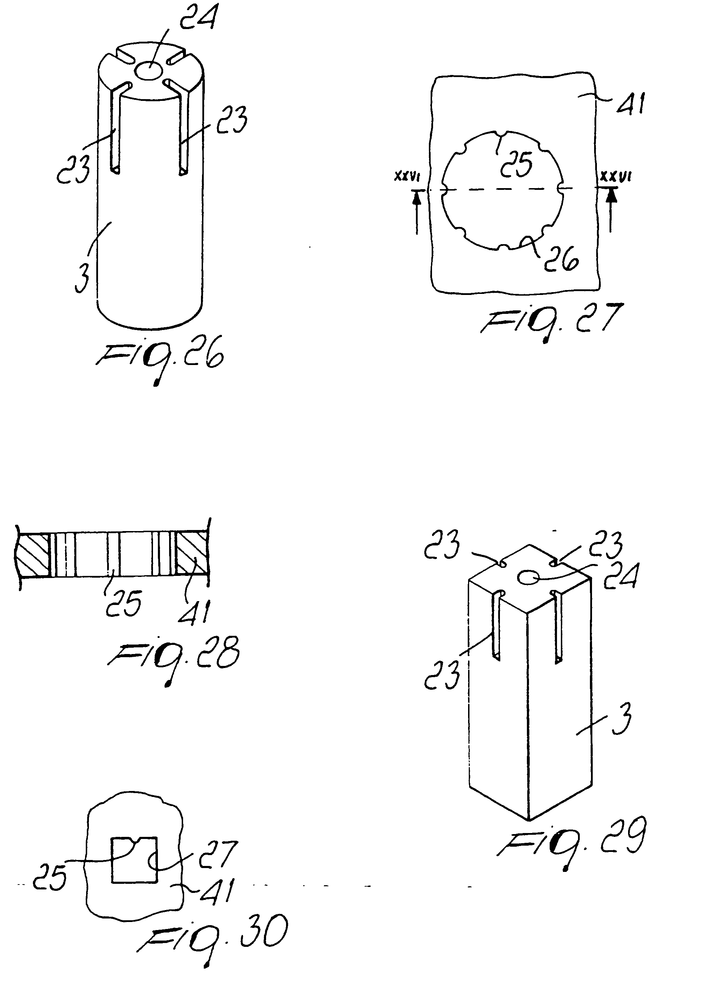

Figures 26 to 34 are views of two embodiments of pins provided with longitudinal slots 23 on their portion 3 adjacent to the conical head 2 or 12 (which can be inserted into the end of the stem through an axial hole 24). The slots 23 are designed to engage with a tooth 25 which extends radially into a seating hole or opening 26 or 27 in a plate 41.

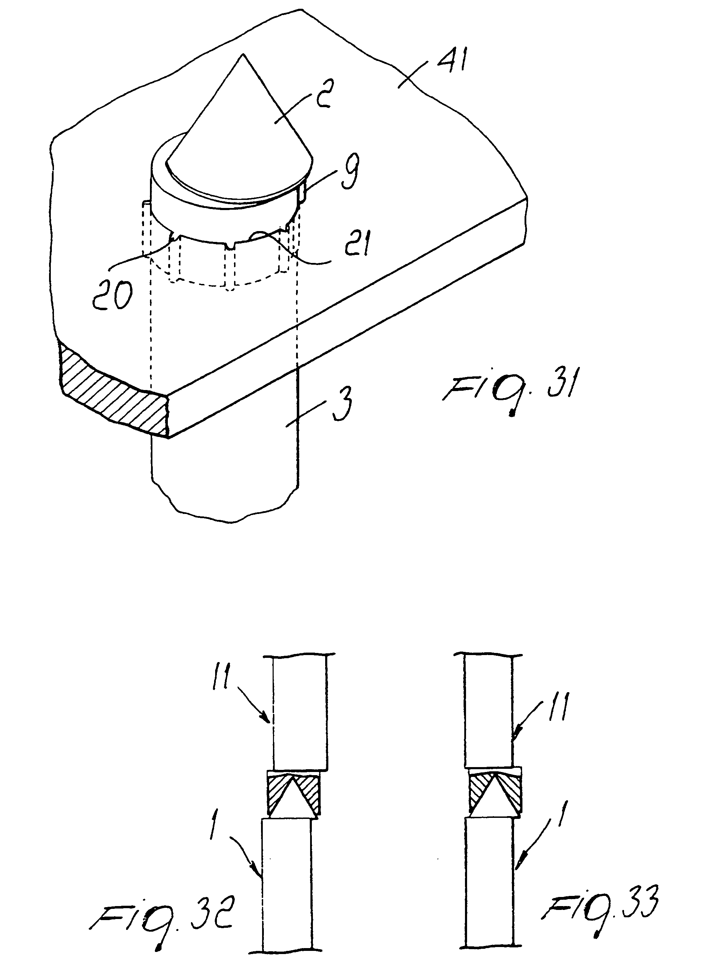

Figures 32 and 33 illustrate couplings between male pins 1 and female pins 11. More particularly, in Figure 32 the angular movement of an upper female pin 11 with respect to a lower male pin 1 is equal to the sum of the eccentricities of the two pins (maximum eccentricity), whereas in Figure 33 the eccentricities of the two pins compensate each other (zero eccentricity), and thus their longitudinal axes are aligned.

Owing to the eccentricity of the heads 2 or 12, the pins 1 or 11 allow alignment or spacing error (usually on the order of a few tenths of a mm) to between the measurement pads 15 (which are all displaced in the same direction) and the reference or centering holes 16 to be compensate by correctly setting the angular arrangement of said pins in their receiving holes or openings 21, 26 and 27 and by keeping them engaged in the intended angular configuration so as to orientate their eccentricity in opposite or contrasting direction, in order to neutralize any misalignment of the pads on the board to be tested.

With reference to Figure 34, boards with printed circuits on a single side are tested by using a single test fixture or frame 52 arranged below the circuit, whereas boards with printed circuits on both sides are tested by using two mutually opposite test frames. In this latter case, alignment is obtained with respect to one of the fixtures or frames by using male pins 1 in one frame and female pins 11 in the other.

Of course, as it is known, in order to decide in which way to orientate the eccentricity of the pins 1 or 11 one establishes by using a microscope (preferably of the type with graduated grid) the direction of misalignment of the pads 15 on the board and the pins 1 and/or 11 are steered accordingly in the frame 52 with their eccentricity in contrast with the observed misalignment direction, thereby compensating any deviation, so that each testing needle correctly abuts against a respective pad, as designed.

Figure 35 schematically illustrates a test frame 52 in which a belt 48 extends around three pins 1; said belt is preferably made of elastic material in order to cause small simultaneous angular movements which are identical for all the pins 1 for carrying out manual angular adjustments, even of the micrometric type, of said pins within their seating holes or openings.

The above described invention is susceptible of numerous modifications and variations within the scope as defined by the tenor of the claims.

## Claims

1. A frame for testing a board (14) having a printed circuit on at least one side thereof and provided with reference centering holes (16), including a plurality of test plates (41a,41b,41c,41d) made of insulating material, for spacing and fixing means for said plates, and a plurality of testing needles or pins (1), **characterized in that** it comprises at least one pin (1) which has one eccentric end (2) arranged to engage a board (14) to be tested and to be inserted in a seat (21) provided in at least one of said plates according to a preset angular orientation of its eccentricity, thereby inducing a corresponding rotation and translatory motion in the board to be tested in order to compensate for manufacturing misalignments of said printed circuit with respect to reference centering holes (16).

2. The frame according to claim 1, **characterized in that** each seat (21) has a plurality of angularly spaced recesses (20) and each pin (1) has a key (9) movably engageable with a recess (20) in a seat (21).

3. The frame according to claim 1, **characterized in that** each seat (21) is provided with a protrusion (25) and each pin (1) has a plurality of angularly spaced recesses (23) removably engageable with a protrusion (25).

4. The frame according to any preceding claim, **characterized in that** the eccentrically-shaped end (2) of at least one pin (1) has a conical tip.

5. The frame according to any claim 1 to 3, **characterized in that** the eccentrically-shaped end (2) of at least one pin (1) has a conical cavity (12).

6. The frame according to any preceding claim, **characterized in that** an actuation belt (48) is wound around said pins (1) to effect small coordinated manual angular movements of said pins (1).

7. A pin for a testing frame according to one or more of the preceding claims, **characterized in that** it has an eccentrically-shaped end.

8. The pin according to claim 7, **characterized in that** it comprises a protrusion or a key (9) for detachable engagement with multiple angular orientations in a suitable seat.

9. The pin according to claim 8, **characterized in that** said protrusion or key (9) is provided at said eccentrically-shaped end.

## Patentansprüche

1. Gestell zum Testen einer Leiterplatte (14), die auf mindestens einer ihrer Seiten eine gedruckte Schaltung hat und mit Referenzzentrierungslöchern (16) versehen ist, das mehrere aus Isoliermaterial gefertigte Testplatten (41a, 41b, 41c, 41d), Einrichtungen zum Beabstanden und Befestigen dieser Platten und mehrere Testnadeln oder Stifte (1) aufweist, **dadurch gekennzeichnet, daß** es zumindest einen Stift (1) aufweist, der ein exzentrisches Ende (2) hat, das so angeordnet ist, daß es in eine zu testende Leiterplatte (14) eingreift, und entsprechend einer voreingestellten Winkelausrichtung mit dessen Exzentrizität in eine Auflagefläche (21) eingeführt wird, die in mindestens einer der Platten vorgesehen ist, wodurch eine entsprechende Dreh- und Verschiebungsbewegung in der zu testenden Leiterplatte hervorgerufen wird, um herscellungsbedingte Fehlausrichtungen der gedruckten Schaltung relativ zu den Referenzzentrierungslöchern (16) zu kompensieren.

2. Gestell nach Anspruch 1, **dadurch gekennzeichnet, daß** jede Auflagefläche (21) mehrere gewinkelt beabstandete Aussparungen (20) hat und jeder Stift (1) einen Schlüssel (9) hat, der beweglich in Eingriff mit einer Aussparung (20) in einer Auflagefläche (21) gebracht werden kann.

3. Gestell nach Anspruch 1, **dadurch gekennzeichnet, daß** jede Auflagefläche (21) mit einem Vorsprung (25) versehen ist und jeder Stift (1) mehrere gewinkelt beabstandete Aussparungen (23) hat, die abnehmbar mit einem Vorsprung (25) in Eingriff gebracht werden können.

4. Gestell nach einem der vorhergehenden Ansprüche, **dadurch gekennzeichnet, daß** das exzentrisch geformte Ende (2) mindestens eines Stifts (1) eine kegelförmige Spitze hat.

5. Gestell nach einem der Ansprüche 1 bis 3, **dadurch gekennzeichnet, daß** das exzentrisch geformte Ende (2) mindestens eines Stifts (1) einen kegelförmigen Hohlraum (12) hat.

6. Gestell nach einem der vorhergehenden Ansprüche, **dadurch gekennzeichnet, daß** ein Antriebsriemen (48) um die Stifte (1) gewickelt ist, um kleine koordinierte manuelle Winkelbewegungen der Stifte (1) zu bewirken.

7. Stift für ein Testgestell nach einem oder mehreren der vorhergehenden Ansprüche, **dadurch gekennzeichnet, daß** er ein exzentrisch geformtes Ende hat.

8. Stift nach Anspruch 7, **dadurch gekennzeichnet, daß** er einen Vorsprung oder einen Schlüssel (9) für das lösbare Ineinandergreifen mit mehreren Winkelausrichtungen in eine geeignete Auflagefläche aufweist.

9. Stift nach Anspruch 8, **dadurch gekennzeichnet, daß** der Vorsprung oder Schlüssel (9) an dem exzentrisch geformten Ende vorgesehen ist.

## Revendications

1. Un cadre pour tester une planche (14) munie d'un circuit imprimé sur au moins l'une de ses faces et pourvue de trous de centrage (16) de référence, comprenant une pluralité de plaques de test (41 a, 4 1 b, 41 c, 4 1 d) réalisée en matériau isolant, de moyens d'espacement et de fixation par lesdites plaques, et d'une pluralité d'aiguilles ou de broches (1) de test, **caractérisé en ce qu'**il comprend au moins une broche (1) qui présente une extrémité excentrique (2) agencée pour venir en contact avec une planche (14) à tester et destinée à être insérée dans un siège (21) prévu dans au moins l'une desdites plaques en correspondance à une orientation angulaire prédéterminée de son excentricité, de sorte à induire un déplacement correspondant de rotation et de translation dans la planche à tester afin de compenser les désalignements de fabrication dudit circuit par rapport aux trous de centrage (16) de référence.

2. Le cadre selon la revendication 1, **caractérisé en ce que** chaque siège (21) comporte une pluralité de cavités (20) angulairement espacées et chaque broche (1) comporte une clé (9) susceptible de venir en contact avec une cavité (20) dans un siège (21).

3. Le cadre selon la revendication 1, **caractérisé en ce que** chaque siège (21) est muni d'une saillie (25) et chaque broche (1) comporte une pluralité de cavités (23) angulairement espacées et susceptibles de venir en contact de façon amovible avec une saillie (25).

4. Le cadre selon l'une quelconque des revendications précédentes, **caractérisé en ce que** l'extrémité (2) de forme excentrique d'au moins une broche (1) présente une pointe conique.

5. Le cadre selon l'une quelconque des revendications 1 à 3, **caractérisé en ce que** l'extrémité (2) de forme excentrique d'au moins une broche (1) comporte une cavité conique (12).

6. Le cadre selon l'une quelconque des revendications précédentes, **caractérisé en ce qu'**une courroie d'actionnement (48) est enroulée autour desdites broches (1) pour effectuer de petits déplacements angulaires manuels coordonnés desdites broches (1)

7. Une broche pour un cadre de test selon l'une ou plusieurs des revendications précédentes, **caractérisée en ce qu'**elle présente une extrémité de forme excentrique.

8. La broche selon la revendication 7, **caractérisée en ce qu'**elle comprend une saillie ou une clé (9) pour une mise en contact amovible selon des orientations angulaires multiples dans un siège approprié.

9. La broche selon la revendication 8, **caractérisée en ce que** ladite saillie ou clé (9) est prévue sur ladite extrémité de forme excentrique.
